(19) Europäisches Patentamt
European Patent Office
Office européen des brevets

(11) Veröffentlichungsnummer: **0 295 211 B1**

(12) # EUROPÄISCHE PATENTSCHRIFT

(45) Veröffentlichungstag der Patentschrift: **16.03.94**

(51) Int. Cl.$^5$: **G03F 7/004**

(21) Anmeldenummer: **88810362.9**

(22) Anmeldetag: **02.06.88**

(54) **Photoresistzusammensetzungen.**

(30) Priorität: **12.06.87 CH 2214/87**

(43) Veröffentlichungstag der Anmeldung:
**14.12.88 Patentblatt 88/50**

(45) Bekanntmachung des Hinweises auf die Patenterteilung:
**16.03.94 Patentblatt 94/11**

(84) Benannte Vertragsstaaten:
**BE CH DE ES FR GB IT LI NL SE**

(56) Entgegenhaltungen:
**EP-A- 294 333**
**EP-A- 0 265 373**

(73) Patentinhaber: **CIBA-GEIGY AG**
**Klybeckstrasse 141**
**CH-4002 Basel(CH)**

(72) Erfinder: **Meier, Kurt, Dr.**
**Im Kirschsgarten 35**
**CH-4102 Binningen(CH)**
Erfinder: **Losert, Ewald**
**Habsburgerstrasse 30**
**CH-4310 Rheinfelden(CH)**



Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Erfindung betrifft positiv arbeitende Photoresistzusammensetzungen und ein Verfahren zur Erzeugung von positiven Abbildungen.

Photoresistzusammensetzungen sind bekannt und in zahlreichen Veröffentlichungen beschrieben, z.B. in DeForest, Photoresist Materials and Processes, McGraw-Hill Book Company, New York, 1975. Photoresists umfassen aus einer Lösung hergestellte Ueberzüge oder als Trockenfilm aufgetragene Ueberzüge, die, wenn sie Licht geeigneter Wellenlänge ausgesetzt werden, hinsichtlich ihrer Löslichkeit in bestimmten Lösungsmitteln (Entwicklern) chemisch verändert werden. Es sind zwei verschiedene Arten bekannt. Der negativ arbeitende Resist ist ursprünglich ein in seinem Entwickler lösliches Gemisch, wird aber nach der Belichtung durch aktivierende Strahlung in dem Entwickler unlöslich und definiert somit ein latentes Bild. Uebliche positive Resists arbeiten umgekehrt; die Belichtung macht den Resist im Entwickler löslich.

In der DE-OS 22 58 880 wird eine positive Photoresistzusammensetzung beschrieben, welche ein Epoxidharz, ein tertiäres Amin, einen halogenierten Kohlenwasserstoff, Dicyandiamid und ein Lösungsmittel enthält. Indem man das Harz einer chemisch wirksamen Strahlung aussetzt, wird erreicht, dass das so mit Amin und halogeniertem Kohlenwasserstoff versetzte Epoxidharz langsamer aushärtet. Das dort beschriebene System genügt jedoch bezüglich Empfindlichkeit den hohen Anforderungen nicht, die an eine positiv arbeitende Photoresistzusammensetzung gestellt werden.

Die vorliegende Erfindung betrifft positiv arbeitende Photoresistzusammensetzungen, enthaltend

(a) ein thermisch härtbares Epoxidharz,

(b) einen latenten Harnstoff- oder Imidazol-Härter für die Komponente (a), und

(c) einen Eisen-aren-Komplex der Formel (I)

$$[R^1(Fe^{II}R^2)]_n^{+n}[X]_m^{-m}{}_n \qquad (I),$$

worin n 1 oder 2 bedeutet, m 1, 2, 3, 4 oder ist, X für ein nicht nukleophiles Anion steht, $R^1$ ein $\pi$-Aren ist und $R^2$ ein Anion eines $\pi$-Arens bedeutet.

Die als Komponente (a) erwähnten polymerisierten Epoxidharze sind insbesondere die Di- und Polyepoxide und Epoxidharzpräpolymere der zur Herstellung vernetzter Epoxidharze verwendeten Art. Die Di- und Polyepoxide können aliphatische, cycloaliphatische oder aromatische Verbindungen sein. Beispiele für solche Verbindungen sind die Glycidylether und $\beta$-Methylglycidylether aliphatischer oder cycloaliphatischer Diole oder Polyole, zum Beispiel solche des Ethylenglykols, Propan-1, 2-diols, Propan-1,3-diols, Butan-1,4-diols, 1,1,2,3,3-Pentahydroxycyclohexan Diethylenglykols, Polyethylenglykols, Polypropylenglykols, Glycerins, Trimethylolpropans oder 1,4-Dimethylolcyclohexans oder des 2,2-Bis-(4-hydroxycyclohexyl)-propans; die Glycidylether von Di- und Polyphenolen, beispielsweise Resorcin, 4,4′-Dihydroxydiphenylmethan, 4,4′-Dihydroxydiphenyl-2,2-propan, Novolake und 1,1,2,2-Tetrakis-(4-hydroxyphenyl)-ethan.

Weitere Glycidylverbindungen mit technischer Bedeutung sind die Glycidylester von Carbonsäuren, insbesondere Di- und Polycarbonsäuren. Beispiele dafür sind die Glycidylester der Bernsteinsäure, Adipinsäure, Azelainsäure, Sebacinsäure, Phthalsäure, Terephthalsäure, Tetra- und Hexahydrophthalsäure, Isophthalsäure oder Trimellitsäure, oder von dimerisierten Fettsäuren.

Beispiele für von Glycidylverbindungen verschiedene Polyepoxide sind die Diepoxide des Vinylcyclohexans und Dicyclopentadiens, 3-(3′,4′-Epoxicyclohexyl)-8,9-epoxy-2,4-dioxaspiro[5.5]undecan, der 3′, 4′-Epoxicyclohexylmethylester der 3,4-Epoxicyclohexancarbonsäure, Butadiendiepoxid oder Isoprendiepoxid, epoxidierte Linolsäurederivate oder epoxidiertes Polybutadien.

Bevorzugte Epoxidharze sind gegebenenfalls vorverlängerte Diglycidylether zweiwertiger Phenole oder zweiwertiger aliphatischer Alkohole mit 2 bis 4 Kohlenstoffatomen. Besonders bevorzugt werden Epoxynovolake, die gegebenenfalls vorverlängerten Diglycidylether des 2,2-Bis-(4-hydroxyphenyl)-propans und Bis-(4-hydroxyphenyl)-methans und Glycidylether von Kresolnovolake.

Die Komponenten (a) sind bekannt und deren Wahl unkritisch, solange sie keine funktionellen Gruppen enthalten, welche mit der Komponente (c) Reaktionen eingehen.

Die als Komponente (b) eingesetzten Harnstoff- oder Imidazol-Härter sind ebenfalls bekannte Verbindungen und vielfach handelsüblich. Mit dem Begriff "latent" wird klargestellt, dass nur Härtungsmittel gemeint sind, welche eine Härtungsreaktion bei niedrigen Temperaturen nicht ermöglichen. Für die erfindungsgemässe Anwendung ist es zweckmässig, Härter (b) zu verwenden, mit welchen die Härtungsreaktion erst bei erhöhter Temperatur abläuft, vorzugsweise über 80 °C und insbesondere über 100 °C.

Beispiele geeigneter Härter sind z.B. Imidazol, 1-Methylimidazol, 2-Methylimidazol, 2-Ethyl-4-methylimidazol, 2,4-Dimethylimidazol, 2-Phenylimidazol, 1-Vinyl-2-methylimidazol, 2-Chlor-4-(N',N'-Dimethylureido)-toluol, 2-(N',N'-Dimethylureido)-phenol, 4-(N',N'-Dimethylureido)-chlorbenzol etc.

Unter den latenten Härtern sind Imidazol und dessen Derivate bevorzugt.

Die Menge des zugesetzten Härters (b) ist dem Fachmann bekannt und beträgt üblicherweise 0,1-10 Gew.-%, bevorzugt 0,5-5 Gew.-%, bezogen auf das Harz (a).

Die Eisen-aren-komplexe (c) sind bekannte Verbindungen. Stoffe dieses Typs sind z.B. in der EP-A-94,915 als Photoinitiatoren für kationisch photo-polymerisierbare Materialien beschrieben worden.

Für die Bedeutung der Reste $R^1$ und $R^2$ in der Formel I wird auf die EP-A 126,712, S. 3 ff. verwiesen. Die in der vorliegenden Erfindung bevorzugten Bedeutungen von $R^1$ sind Cumol, Naphthalin, Methylnaphthalin, Pyren oder Stilben und für $R^2$ Cyclopentadienyl.

Beispiele für X in der Formel I sind $BF_4^{\ominus}$, $PF_6^{\ominus}$, $AsF_6^{\ominus}$, $SbF_6^{\ominus}$, $SbF_5OH^{\ominus}$; Sulfonate, wie Methylsulfonat oder p-Toluolsulfonat; Perfluoralkylsulfonate, wie Trifluormethylsulfonat, Nonafluorabutylsulfonat; Acetate, z.B. $CH_3COO^{\ominus}$; Perfluoracetate, z.B. $CF_3COO^{\ominus}$; Halogenide, wie $F^{\ominus}$, $Cl^{\ominus}$, $Br^{\ominus}$, $I^{\ominus}$; Pseudohalogenide, z.B. $CN^{\ominus}$, $SCN^{\ominus}$ u.a. Besonders bevorzugt werden Sulfonate und Perfluoralkylsulfonate.

Vorzugsweise enthalten die erfindungsgemässen Zusammensetzungen 0,5-20 Gew.-%, insbesondere 1-5 Gew.-% der Komponente (c), bezogen auf das Harz (a).

Die erfindungsgemässen Zusammensetzungen zeichnen sich dadurch aus, dass sich belichtete Stellen in ihrer Härtbarkeit deutlich von den nicht belichteten Stellen unterscheiden. Dadurch wird erreicht, dass die nicht belichteten Stellen nach thermischer Behandlung derart ausgehärtet sind, dass sie in üblichen Entwicklungsmitteln weitgehend unlöslich sind, während sich die belichteten Stellen in einem noch weitgehend ungehärten Zustand befinden, so dass sie im gleichen Entwicklungsmittel praktisch ganz löslich sind. Auf diese Weise gelingt, es Positivresists mit ausgezeichneten Temperatur- und Chemikalieneigenschaften zu erhalten. Ueberraschenderweise wird die thermische Härtung an den nicht belichteten Stellen nicht beeinträchtigt und es genügen bereits kurze Belichtungszeiten für gute Resultate.

Die vorliegende Erfindung betrifft ferner ein Verfahren zur Erzeugung positiver Abbildungen umfassend folgende Arbeitsschritte:

- Beschichten eines Substrats mit einer positiv arbeitenden Photoresistzusammensetzung enthaltend
  (a) ein thermisch härtbares Epoxidharz,
  (b) einen latenten Harnstoff- oder Imidazol-Härter für die Komponente (a), und
  (c) einen Eisen-aren-komplex der Formel (I)

  $$[R^1(Fe^{II}R^2)_n]_m^{+n}\,[X]_n^{-m} \qquad (I),$$

worin n 1 oder 2 bedeutet, m 1, 2, 3, 4 oder 5 ist, X für ein nicht nukleophiles Anion steht, $R^1$ ein $\pi$-Aren ist und $R^2$ ein Anion eines $\pi$-Arens bedeutet,

- Belichten des beschichteten Substrats mit einem vorbestimmten Muster aktinischer Strahlung
- Härtung des belichteten Substrats bei erhöhter Temperatur, und
- Entwicklung des Substrats
- gegebenenfalls Strippen.

Die Herstellung der beschichteten Substrate kann z.B. erfolgen, indem man eine Lösung oder Suspension der Zusammensetzung herstellt. Die Wahl des Lösungsmittels und die Konzentration richten sich hauptsächlich nach der Art der Zusammensetzung und nach dem Beschichtungsverfahren. Die Lösung wird mittels bekannten Beschichtungsverfahren auf ein Substrat gleichförmig aufgebracht, z.B. durch Schleudern, Tauchen, Rakelbeschichtung, Vorhanggiessverfahren, Aufpinseln, Sprühen, Elektrostat. Sprühen und Reverse Rollbeschichtung. Es ist auch möglich, die lichtempfindliche Schicht auf einen temporären, flexiblen Träger zu bringen, und dann durch Schichtübertragung via Lamination das endgültige Substrat, z.B. eine kupferkaschierte Leiterplatte, zu beschichten.

Die Auftragsmenge (Schichtdicke) und Art des Substrates (Schichtträger) sind abhängig vom gewünschten Applikationsgebiet. Besonders vorteilhaft ist es, dass die erfindungsgemässen Zusammensetzungen in breit variablen Schichtdicken eingesetzt werden können.

Mögliche Einsatzgebiete der erfindungsgemässen Zusammensetzungen sind die Verwendung als Photoresists für die Elektronik (Galvanoresist, Aetzresist) Lötstopplacke, die Herstellung von Druckplatten, wie Offsetdruckplatten für den autotypischen Tiefdruck oder für den Rollodruck und ferner für die Herstellung von Siebdruckformen, der Einsatz beim Formteilätzen oder der Einsatz als Mikroresist bei der Herstellung integrierter Schaltkreise.

Dementsprechend unterschiedlich sind die möglichen Schichtträger und die Verarbeitungsbedingungen der beschichteten Substrate.

Für photographische Informationsaufzeichnung dienen z.B. Folien aus Polyester, Celluloseacetat oder mit Kunststoff beschichtete Papiere; für Offsetdruckformen speziell behandeltes Aluminium und für die Herstellung gedruckter Schaltungen kupferkaschierte Laminate oder geätzte Leiterplatten.

Nach Beschichten wird das Lösungsmittel in der Regel durch Trocknen entfernt und es resultiert eine Schicht des Photoresist auf dem Träger.

Nach der in üblicher Weise erfolgten bildmässigen Belichtung des Materials werden die belichteten Stellen des Photolackes durch Herauslösen in einem Entwickler entfernt.

Besonders bevorzugt als Entwickler werden wässrig alkalische Lösungen, wie sie für die Entwicklung von Naphthochinondiazidschichten eingesetzt werden. Dazu zählen insbesondere wässrige Lösungen von Alkalimetallsilikaten, -phosphaten und -hydroxiden oder Tetraalkylammoniumverbindungen. Diese Lösungen können gegebenenfalls noch kleinere Mengen an Netzmitteln und/oder organischen Lösungsmitteln zugesetzt sein.

Typische organische Lösungsmittel, sind solche, die mit Wasser mischbar sind und den Entwicklerflüssigkeiten zugesetzt werden können, wie beispielsweise 2-Ethoxyethanol oder Aceton, sowie Mischungen zweier oder mehrerer solcher Lösungsmittel.

Der Begriff 'Belichtung mit einem vorbestimmten Muster aktinischer Strahlung' beinhaltet sowohl die Belichtung durch eine Photomaske, die ein vorbestimmtes Muster enthält, beispielsweise ein Diapositiv, sowie die Belichtung durch einen Laserstrahl, der beispielsweise computergesteuert über die Oberfläche des beschichten Substrates bewegt wird, und auf diese Weise ein Bild erzeugt.

Die Lichtempfindlichkeit der erfindungsgemässen Zusammensetzungen reicht in der Regel vom UV-Gebiet (ca. 250 nm) bis ca. 600 nm und umspannt somit einen sehr breiten Bereich. Als Lichtquellen kommen daher eine grosse Anzahl der verschiedensten Typen zur Anwendung. Es sind sowohl Punktlichtquellen als auch flächenförmige Strahler (Lampenteppiche) geeignet. Beispiele sind: Kohlelichtbogenlampen, Xenon-Lichtbogenlampen, Quecksilberdampflampen, gegebenenfalls mit Metall-Halogeniden dotiert (Metall-Halogenlampen), Fluoreszenzlampen, Argonglühlampen, Elektronenblitzlampen und photographische Flutlichtlampen. Der Abstand zwischen Lampen und erfindungsgemässen Bildmaterial kann je nach Anwendungszweck und Lampentyp bzw. -stärke variieren, z.B. zwischen 2 cm bis 150 cm. Speziell geeignet sind Laserlichtquellen, z.B. Argonionenlaser oder Kryptonionenlaser mit starken Emissionslinien (Ar-Laser) bei 457, 476, 488, 514, 528 nm. Bei dieser Art der Belichtung ist keine Photomaske im Kontakt mit der Photopolymerschicht mehr nötig; der gesteuerte Laser-Strahl schreibt direkt auf die Schicht. Hier ist die hohen Empfindlichkeit der erfindungsgemässen Materialien sehr vorteilhaft, die hohe Schreibgeschwindigkeiten bei relativ niedrigen Intensitäten erlaubt. Nach dieser Methode können gedruckte Schaltungen in der Elektronikindustrie, lithographische Offsetdruckplatten oder Reliefdruckplatten sowie photographische Bildaufzeichnungsmaterialien hergestellt werden.

Das Härten der belichteten Zusammensetzungen erfolgt nach üblichen Methoden, z.B. durch Erwärmen in Konvektionsöfen. Die Härtungstemperatur liegt im allgemeinen bei etwa 80 bis 350 °C, insbesondere bei 100 bis 200 °C. Die Härtungsdauer beträgt je nach Zusammensetzung und Temperatur 1 bis 60 min, insbesondere 3 bis 30 min.

Die erfindungsgemässen Photresistzusammensetzungen können gegebenenfalls auch Sensibilisatoren für die Komponente (c) enthalten. Beispiele dafür sind:
Perylen, 9,10-Dichloranthracen, 9,10-Diphenylanthracen, 3,4-Benzopyren, 1-Chloranthracen, 2-Methylanthracen, 9-Methylanthracen, 2-t-Butylanthracen, Anthracen, 1,12-Benzperylen, trans-1,3,5,-Hexatrien, 1,2-Benzanthracen, Pyren, Pentaphen, Diphenyltetraacetylen, trans-Stilben, 1,2,3,4-Dibenzanthracen, 1,2,5,6-Dibenzanthracen, 1,3-Cyclohexadien, 1,2,7,8-Dibenzanthracen, 1,2-Benzopyren, Fluoranthen, 1,2-Benzochrysen, Tetraacetylenglykol, Diethyltetraacetylen, 1-Aminonaphthalin, Benzil, Coronen, 1-Nitronaphthalin, 3,4-Benzofluoren, Diphenyltriacetylen, 2,2'-Binaphthyl, 1-Naphthaldehyd, 5,6-Benzochrysen, 1-Acetylnaphthalin, 3,4,5,6-Dibenzophenanthren, cis-Stilben, 2,3-Butandion, Chrysen, 1,2-Benzofluoren, 2,3-Benzofluoren, 1-Benzoylnaphthalin, 1-Naphthonitril, Naphthalin-1-carbonsäure, Diphenyldiacetylen, 1,2,6,7-Dibenzopyren, Cyclopentadien, 9-Acetylphenanthren, p-Terphenyl, 1-Naphthol, 1-Iodonaphthalin, 2-Phenylnaphthalin, 3,4-Benzophenanthren, 3-Acetylphenanthren, 1-Bromnaphthalin, 1-Chlornaphthalin, 2-Naphthonitril, Acenaphthen, trans-1,3-Pentadien, 2-Naphthaldehyd, Naphthalin-2-carbonsäure, 2-Acetylnaphthalin, 2-Benzoylnaphthalin, 2,4-Hexadien-1-ol, 1-Methylnaphthalin, 1-Methoxynaphthalin, 1,3-Butadien, 1-Fluornaphthalin, Isopren, 2-Iodnaphthalin, 2-Bromnaphthalin, 2-Chlornaphthalin, 2-Naphthol, 4-Phenylbenzophenon, 4-Phenylacetophenon, 2-Methylnaphthalin, Naphthalin, o-Terphenyl, Styrol, Phenanthren, 4,4'-Bis-dimethylaminobenzophenon, Diphenylacetylen, Anthrachinon, 4,4'-Dichlorbiphenyl, Triacetylengykol, 4-Hydroxybiphenyl, 2,4,6-Octatriyn, m-Terphenyl, 2-Brombiphenyl, Thioxanthon, 2-Isopropylthioxanthon, 2-Chlorthioxanthon, 2-Dodecylthioxanthon, 1-Methoxycarbonylthioxanthon, 2-Ethoxycarbonylthioxanthon, 3-(2-Methoxyethoxycarbonyl)-thioxanthon, 4-Butoxycarbonylthioxanthon, 1-Cyano-3-chlorthioxanthon, Biphenyl, 3,4-Methylendioxyacetophenon, 4-Cyanobenzophenon, Triphenylen, 4-Benzoylpyridin, 2-Benzoylpyridin, Fluoren, 4,4'-Dichlorbenzophenon, 4-Trifluormethylbenzophenon, 3-Methoxybenzophenon, 4-Chlorbenzophenon, 3-Chlorbenzophenon, 4,4'-Dibrombenzophenon, 3-Benzoylpyridin, 4-Methoxybenzophenon, 3,4-Dimethylbenzophenon, 4-Methylbenzophenon, Benzophenon, 2-Methylbenzophenon, 4,4'-Dimethylbenzophenon, 2,5-Dimethylbenzophenon, 2,4-Dimethylbenzophenon, 4-Cyanoacetophenon, 4-Fluorbenzophenon, o-Benzylbenzophenon, α-Chloracetophenon, Diphenylenoxyd, Carbazol, 4,4'-Dimethoxybenzophenon, 4-Acetylpyridin, 3,4,5-Trimethylacetophenon, p-Dicyanobenzol, 4-Methoxybenzaldehyd, 4-Methylbenzaldehyd, 3,5-Dimethylacetophenon, 4-Bromacetophenon, 4-Methoxyacetophenon, 3,4-Dimethylacetophenon, Benzaldehyd, Triphenylmethylacetophenon, Anthron, 4-Chloracetophenon, 4-Trifluormethylacetophenon, Phenylacetylen, 2,4,6-Trimethylacetophenon, 3-Methoxyacetophenon, 3-Methylacetophenon, o-Dicyanobenzol, 1-Tetralon, 3-Bromacetophenon, 4-Methylacetophenon, 3-Cyanoacetophenon, 3-Trifluormethylacetophenon, Hexachlorbenzol, Xanthon, Acetophenon, 2-Phenylbutyrophenon, Allylacetophenon, β-Phenylpropionphenon, Valerophenon, Propiophenon, Butyrophenon, 2-Ethoxycarbonyl-3-nitrothioxanthon, 3-Thiophenylphthalimid, N-Methyl-4-thiophenylphthalimid.

Bevorzugt sind Anthracene, Phthalimidthioether und besonders Thioxanthone. Diese werden bevorzugt in einer Menge von 0,2-10 Gew.-%, vorzugsweise 0,5-5 Gew.-% zugegeben, bezogen auf das Epoxidharz.

Ist eine wässrig-alkalische Entwicklung erwünscht, so kann die erfindungsgemässe Resistzusammensetzung ein Bindemittel enthalten, z.B. ein Polyphenol oder ein Gemisch von Polyphenolen, d.h. ein Polymer, das einen bestimmten Gehalt an phenolischen Hydroxylgruppen aufweist. Dieser sollte zumindest so hoch sein, dass die Entwicklung oder zumindest die Quellung in einer wässrig alkalischen Entwicklerlösung gewährleistet ist.

Geeignete alkalisch-wässrig lösliche, filmbildende Bindemittel lassen sich in folgende Gruppen einteilen:

i) Novolake aus mindestens einem Phenol und mindestens einem Aldehyd,
(ii) Homo- und Copolymere von Alkenylphenolen und insbesondere
(iii) Homo- und Copolymere von N-Hydroxyphenylmaleinimiden.

Bevorzugte Novolake i) sind Verbindungen, die sich von einem $C_1$-$C_6$-Aldehyd, beispielsweise Formaldehyd und Acetaldehyd, und von einem einkernigen gegebenenfalls substituierten Phenol ableiten. Beispiele für bevorzugte Phenole sind Phenol selbst oder mit ein oder zwei $C_1$-$C_9$-Alkylgruppen substituierte Phenole, wie beispielsweise o-, m-oder p-Kresol, Xylenol, p-tert.Butylphenol und o- m-oder p-Nonylphenol, oder mit ein oder zwei Halogenatomen, bevorzugt Chlor oder Brom, substituierte Phenole, beispielsweise p-Chlorphenol, mit einem Phenylkern substituierte Phenole, wie z.B. p-Phenylphenol, oder auch Phenole mit mehr als einer phenolischen Gruppen, wie z.B. Resorcin, Bis-(4-hydroxyphenyl)-methan oder 2,2-Bis-(4-hydroxyphenyl)propan.

Bevorzugte Homo- oder Copolymere con Alkenylphenolen ii) sind insbesondere die Verbindungen der Formel II

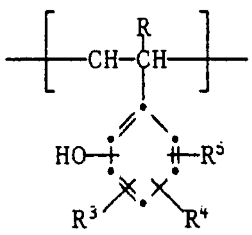

(II),

worin R Wasserstoff oder Methyl ist, $R^3$, $R^4$ und $R^5$ unabhängig voneinander Wasserstoff, $C_1$-$C_4$Alkyl, $C_1$-$C_4$Alkoxy, Halogen, insbesondere Chlor oder Brom, und Methylol bedeuten. Die phenolische Hydroxylgruppe ist in o-, m-oder p-Position zur Alkenylgruppe angeordnet, bevorzugt jedoch in p-Position.

Als Comonomere kommen beispielsweise carboxylgruppenfreie Vinylmonomere in Betracht. Beispiele für solche Monomere sind Styrol, Acryl- und Methyacrylsäureester, insbesondere (Meth)-acrylsäuremethylester oder (Meth)acrylsäure-2-hydroxyethylester, Acrylamid, Vinylacetat und N-substituierte Maleinimide.

Der Comonomerenanteil der Bindemittel des Typs ii) beträgt bevorzugt 0-50 Mol%, bezogen auf das Gesamtpolymere.

Polymere des Typs ii) sind bekannt und beispielsweise in den DE-OS 23 22 230 und 34 06 927 beschrieben. Teilweise sind solche Polymere auch im Handel erhältlich.

Bevorzugte Bindemittel des Typs iii) sind Homopolymere von N-Hydroxyphenylmaleinimiden. Dabei handelt es sich besonders bevorzugt um Homopolymere mit der Struktureinheit der Formel III

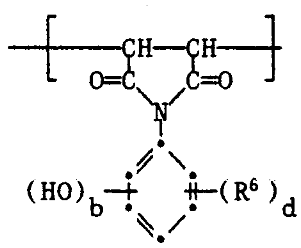

(III),

worin $R^6$ $C_1$-$C_4$Alkyl, $C_1$-$C_4$Alkoxy oder Halogen, insbesondere Chlor oder Brom ist, b 1, 2 oder 3 darstellt, d 0, 1, 2, 3 oder 4 ist und die Summe von b und d höchstens 5 bedeutet, wobei die Reste $R^6$ eines Phenylkernes innerhalb der gegebenen Definitionen unterschiedlich sein können.

Eine weitere bevorzugte Gruppe von Bindemitteln des Typs iii) sind Copolymere auf der Basis von N-Hydroxyphenylmaleinimiden, insbesondere solche mit Strukturelementen der Formel III und carboxylgruppenfreien Vinylverbindungen.

Beispiele für geeignete Vinyl-Comonomere sind:

a) Styroltypen, wie beispielsweise Styrol, $\alpha$-Methylstyrol, p-Methylstyrol oder p-Hydroxyphenylstyrol;

b) Ester oder Amide $\alpha,\beta$-ungesättigter Säuren, wie beispielsweise Acrylsäuremethylester, Acrylsäureamid, die entsprechenden Methacrylverbindungen oder Maleinsäuremethylester;

c) Nitrile von $\alpha,\beta$-ungesättigten Säuren, wie beispielsweise Acrylnitril oder Methacrylnitril;

d) halogenhaltige Vinylverbindungen, wie beispielsweise Vinylchlorid, Vinylfluorid, Vinylidenchlorid oder Vinylidenfluorid;

e) Vinylester, wie beispielsweise Vinylacetat oder

f) Vinylether, wie beispielsweise Methylvinylether oder Butylvinylether.

Der Anteil der Vinylkomponente beträgt in der Regel 0 bis 95 Mol%, bevorzugt 0-75 Mol%, besonders bevorzugt 0-50 Mol%, bezogen auf den Gesamtanteil an Monomereinheiten.

Homopolymere aus Struktureinheiten der Formel III und Copolymere mit Vinylverbindungen sind bekannt und werden beispielsweise in der BE-PS 613,801 sowie in Kobunshi Kagaku, 1969, 26 (292) beschrieben. Ferner berichten Turner et al. in Photopolymer Conference, Ellenville Oct. 1985, S. 35-47 über den Einsatz von solchen Comonomeren mit Vinylverbindungen als Bindemittel in positiven Photolacken.

Eine weitere besonders bevorzugte Gruppe von Bindemitteln des Typs iii) sind Copolymere auf der Basis von N-Hydroxymaleinimiden, insbesondere solche mit Strukturelementen der Formel III, Allylverbindungen und gegebenenfalls weiteren Vinylverbindungen.

Bei diesen Verbindungen handelt es sich insbesondere um Copolymere enthaltend 30-100 Mol%, bezogen auf das Gesamtpolymere, an Struktureinheiten der Formel III, wie oben definiert, und der Formel IV, wobei der Anteil der Reste der Formel III, bezogen auf den gesamten Anteil von III und IV, 5 bis 95 Mol% ausmacht

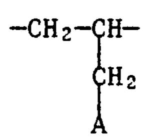

(IV),

worin A ausgewählt wird aus der Gruppe der Reste bestehend aus Halogen, Cyano oder Struktureinheiten der Formeln V bis X

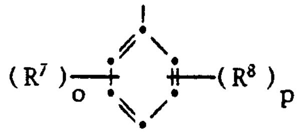 (V), 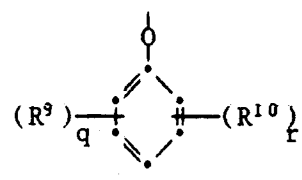 (VI),

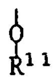 (VII), 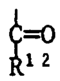 (VIII) 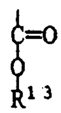 (IX), 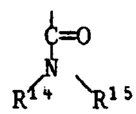 (X),

worin $R^7$ und $R^9$ unabhängig voneinander Hydroxy- oder Glycidylgruppen der Formel XIa oder XIb darstellen

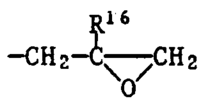 (XIa), 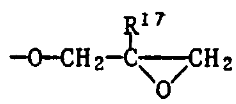 (XIb),

$R^8$ und $R^{10}$ unabhängig voneinander $C_1$-$C_4$Alkyl, $C_1$-$C_4$Alkoxy oder Halogen sind,
o und q unabhängig voneinander 0, 1, 2 oder 3 sind,
p und r unabhängig voneinander 0, 1, 2, 3, 4 oder 5 bedeuten,
wobei die Summen o + p und q + r höchstens 5 betragen dürfen,
$R^{11}$ Wasserstoff, $C_1$-$C_{20}$Alkyl, ein Glycidylrest der Formel XIa oder ein Rest der Formel VIII ist,
$R^{12}$ Wasserstoff, $C_1$-$C_{20}$Alkyl, Cycloalkyl mit 5 bis 7 Ring C-Atomen, Phenyl, Naphthyl oder Benzyl darstellt,
$R^{13}$ Wasserstoff, $C_1$-$C_{20}$Alkyl oder ein Glycidylrest der Formel XIa ist und die Gruppen $R^{14}$ und $R^{15}$ unabhängig voneinander Wasserstoff, $C_1$-$C_{20}$Alkyl, Cycloalkyl mit 5 bis 7 Ring C-Atomen, gegebenenfalls substituiertes Aryl oder Aralkyl oder ein Glycidylrest der Formel XIa sind oder zusammen mit dem gemeinsamen Stickstoffatom einen fünf-oder sechsgliedrigen heterocyclischen Ring bilden und $R^{16}$ und $R^{17}$ unabhängig voneinander Wasserstoff oder Methyl sind, wobei die Reste $R^7$ bis $R^{17}$ und A eines Polymermoleküls innerhalb der gegebenen Definitionen unterschiedlich sein können.

Besonders bevorzugte Bindemittel des Typs iii) sind Copolymere enthaltend 50-100 Mol%, bezogen auf das Gesamtpolymere, an Struktureinheiten der Formeln III und IV.

Insbesondere bevorzugt werden Bindemittel des Typs iii) bestehend im wesentlichen aus Strukturelementen der Formeln III und IV, worin der Anteil der Elemente III 10-80 Mol%, bezogen auf den Anteil von III und IV, ausmacht.

Ganz besonders bevorzugte Bindemittel des Typs iii) sind Copolymere enthaltend Struktureinheiten der Formeln III und IV, wie oben definiert, worin A ausgewählt wird aus der Gruppe der Reste der Formeln V, VI, VII, IX und X, $R^7$ und $R^9$ Glycidylgruppen der Formeln XIa oder XIb darstellen, $R^{11}$, $R^{13}$ und mindestens einer der Reste $R^{14}$ oder $R^{15}$ eine Glycidylgruppe der Formel XIa ist und o und q unabängig voneinander 1, 2 oder 3 sind.

Insbesondere bevorzugt werden Bindemittel des Typs iii), die Struktureinheiten der Formeln III und IV, wie oben definiert, enthalten, worin A eine Gruppe der Formel VII ist und $R^{11}$ eine Gruppe der Formel XIa bedeutet, oder worin A eine Gruppe der Formeln V oder VI ist, $R^7$ und $R^9$ Glycidylgrupen der Formel XIb sind, o und q 1 oder 2 bedeuten und p und r 0 sind.

Weitere Bindemittel des Typs iii) sind Copolymere enthaltend mindestens 50 Mol%, bezogen auf das Gesamtpolymere, an Strukturelementen der Formel III und IV und als restlichen Anteil Strukturelemente, die sich von carboxylgruppenfreien Vinylverbindungen ausgewählt aus der Gruppe bestehend aus Styroltypen, Estern oder Amiden $\alpha,\beta$-ungesättigter Säuren, Nitrilen von $\alpha,\beta$-ungesättigten Säuren, halogenhaltigen Vinylverbindungen, Vinylestern und Vinylethern ableiten.

Wird mit einem organischen Lösungsmittel entwickelt, so verwendet man solche, in denen die verwendeten Epoxidharze löslich sind. Dieser Verfahrensschritt kann mechanisiert und z.B. mit einem Sprühentwicklungsgerät oder einem Durchlaufentwicklungsgerät durchgeführt werden. Eine Entwicklung durch einfaches Ueberwischen oder durch Behandlung mit Lösungsmitteldampf ist ebenfalls möglich.

Geeignete organische Lösungsmittel sind polare, besonders polare, aprotische Lösungsmittel, die alleine oder in Mischungen aus mindestens zwei Lösungsmitteln verwendet werden können. Geeignete Lösungmittel sind zum Beispiel: Ether wie Diethylether, Dibutylether, Tetrahydrofuran, Dioxan, Methylethylenglykol, Dimethylethylenglykol, Dimethyldiethylenglykol, Diethyldiethylenglykol, Dibutyldiethylenglykol, Dimethyltriethylenglykol, halogenierte Kohlenwasserstoffe wie Methylenchlorid, Chloroform, Tetrachlorkohlenstoff, 1,2-Dichlorethan, 1,1,2-Trichlorethan, 1,1,2,2-Tetrachlorethan, Carbonsäureester und Lactone wie Propylencarbonat, Essigsäureethylester, Propionsäuremethylester, Benzoesäureethylester, Ethylglykolacetat, 2-Methoxyethylacetat, $\gamma$-Butyrolacton, $\gamma$-Valerolacton und Mevalolacton, Sulfoxide, wie Dimethylsulfoxid, Tetramethylsulfoxid, Sulfone wie Dimethylsulfon, Diethylsulfon, Trimethylensulfon, Tetramethylensulfon, Ketone wie Dimethylketon, Methylethylketon, Methylisobutylketon und Cyclohexanon, substituierte Benzole wie Chlorbenzol und Nitrobenzol.

Die erfindungsgemässen Zusammensetzungen können auch weitere in der Technik übliche Zusatzstoffe enthalten. Beispiele dafür sind Pigmente, Farbstoffe, Netzmittel, Verlaufmittel, Stabilisatoren, Füllstoffe, Thixotropiemittel, Haftvermittler, Weichmacher und Bindemittel.

Die nachfolgenden Beispiele erläutern die Erfindung näher:

Beispiel 1

Eine Mischung bestehend aus 4 g eines technischen Epoxidkresolnovolaks (Epoxidgehalt 4,5 Aeq/kg), 1 g Talkum, 0,04 g Irgalith® Grün-Pigment, 0,12 g ($\eta^6$-Anisol)($\eta^5$-cyclopentadienyl)eisen(II)-hexafluorophosphat, 0,05 g 2-Methylimidazol und 5 g Cyclohexanon wird mit einem 100 $\mu$ Drahtrakel auf eine kupferkaschierte Epoxidplatte aufgebracht und bei 80 °C getrocknet.

Die Belichtung der so hergestellten Photopolymerplatte erfolgt mit einer 5000-Watt Quecksilberhochdrucklampe, in einem Abstand zum Probentisch von 50 cm, wobei als Vorlage ein 21 step Stouffer sensivity guide verwendet wird (s. W.S. DeForest, Photoresist, McGraw-Hill Book Comp., N.Y., S. 109 ff). Die Belichtungszeit beträgt 15 s., danach wird die belichtete Platte während 15 min. bei 140 °C gehärtet. Die Entwicklung erfolgt in Cyclohexanon, wobei die belichteten Anteile gelöst werden. Es resultiert ein Reliefbild mit der letzten vollständig abgelösten Stufe No. 3.

Beispiel 2

Beispiel 1 wird wiederholt, jedoch mit ($\eta^6$-Isopropylbenzol)($\eta^5$-cyclopentadienyl)eisen(II)-trifluormethansulfonat anstelle von ($\eta^6$-Anisol)($\eta^6$-cyclopentadienyl)eisen(II)-hexafluorphosphat und einem Zusatz von 0,06 g 9-Isopropylthioxanthon als Sensibilisator. Es resultiert nach einer Belichtung von 5 s. und einer Härtung von 5 min. bei 150 °C ein Reliefbild mit der letzten vollständig abgelösten Stufe 2.

Beispiel 3

Eine Mischung bestehend aus 12 g eines technischen Epoxidkresolnovolak (Epoxidgehalt 4,5 Aeq/kg), 5 g eines technischen Bisphenol-A-Epoxidharzes (Epoxidgehalt 0,5 Aeq/kg), 2 g Talkum, 0,06 g Irgalith® Grün-Pigment, 0,2 g ($\eta^6$-Stilben)($\eta^5$-cyclopentadienyl)eisen(II)tosylat, 0,05 g 2-Ethyl-4-methyl-imidazol und 7,5 g 1-Methoxy-2-propanol wird mit einem 100 $\mu$ Drahtrakel auf eine kupferkaschierte Epoxidplatte aufgebracht. Der vorerst nasse Film wird bei 80 °C getrocknet.

Die Belichtung, 10 sek.; Aushärtung, 30 min. bei 130 °C und Entwicklung mit 1-Methoxy-2-propanol erfolgt gemäss Beispiel 1. Es resultiert ein Reliefbild mit der letzten vollständig abgelösten Stufe No. 5.

Beispiel 4

Die Photopolymermischung aus Beispiel 3 wird mit einem 100 $\mu$ Drahtrakel auf eine Polyesterfolie aufgebracht und der vorerst nasse Film bei 80 °C getrocknet. Der feste Resistfilm wird mit Hilfe eines Laminators bei 110 °C auf eine vorgewärmte kupferkaschierte Epoxidplatte übertragen und nach Abkühlen wie in Beispiel 3 beschrieben belichtet, gehärtet und entwickelt. Es resultiert ebenfalls ein Reliefbild mit der letzten vollständig abgelösten Stufe Nr. 5.

Beispiel 5

Die Photopolymermischung aus Beispiel 3 wird mit einem 100 $\mu$ Drahtrakel auf eine Leiterplatte aufgebracht und der vorerst nasse Film bei 80 °C getrocknet. Die Belichtung erfolt mit der in Beispiel 1

beschriebenen Beleuchtungsapparatur während 10 Sekunden durch eine Maske, die die Lötaugen frei lässt. Aushärtung und Entwicklung erfolgt gemäss Beispiel 1.

Die mit Flussmittel (Lösung aus 26 g Reinkolophonium in 100 ml Isopropanol) beschichtete Platte wird mit der Beschichtung nach unten auf ein 270° heisses Lötbad (bestehend aus 50 % Blei und 50 % Zinn) gelegt. Nach 10 Sekunden wird die Platte vom Lötbad entfernt, nach Abkühlen durch Waschen mit Isopropanol vom Flussmittel befreit und mit Pressluft getrocknet.

Resultat: Die Beschichtung zeigt keinerlei sichtbare Veränderung wie Risse, Blasen, Poren oder haftende Zinn/Blei-Rückstände.

Beispiel 6

Eine Mischung bestehend aus 4,8 g eines technischen Poly-p-vinylphenols (MW-1000), 2,8 g Bisphenol-A-diglycidylether, 0,2 g ($\eta^6$-Stilben)($\eta^5$-cyclopentadienyl)eisen(II)-tosylat, 0,1 g 1-Vinylimidazol, 0,016 g Maxilonrot®-Pigment, 4 g Methylethylketon und 4 g Methylcellosolve wird mit einem 100 µ Drahtrakel auf eine kupferkaschierte Epoxidplatte aufgebracht und bei 80°C getrocknet.

Es resultiert nach einer Belichtung von 15 sek., Härtung von 5 min. bei 120°C ein Reliefbild mit der letzten vollständig abgelösten Stufe 5 (Entwickler: Lösung aus 37,5 g Natriummetasilikat Pentahydrat und 0,2 g Supronic B50, ABM Chemicals Ltd, in 1 Liter Wasser).

Beispiel 7

Eine Lösung bestehend aus 6 g eines technischen Epoxidkresolnovolakes (Epoxidgehalt 4,5 Aeq/kg), 3 g eines technischen Bisphenol-A-Epoxidharzes (Epoxidgehalt 0,5 Aeq/kg), 0,2 g ($\eta^6$-Stilben)($\eta^5$-Cyclopentadienyl)eisen(II)-tosylat, 0,076 g 2-(N',N'-Dimethylureido)-phenol, 3 g 1-Methoxy-2-propanol und 6 g Cyclohexanon wird mit einem 100 µ Drahtrakel auf eine kupferkaschierte Epoxidplatte aufgebracht. Der vorerst nasse Film wird bei 80°C getrocknet.

Die Belichtung, 30 Sekunden; Aushärtung, 30 Minuten bei 135°C und Entwicklung in Cyclohexanon erfolgt gemäss Beispiel 1. Es resultiert ein Reliefbild mit der letzten vollständig abgelösten Stufe 9.

Beispiel 8

Beispiel 7 wurde wiederholt, wobei das 2-(N',N'-Dimethylureido)-phenol mit 0,126 g 2-Chlor-4-(N',N'-dimethylureido)-toluol ersetzt wird. Es resultiert ein Reliefbild mit der letzten vollständig abgelösten Stufe 9.

## Patentansprüche

**1.** Positiv arbeitende Photoresistzusammensetzungen, enthaltend
(a) ein thermisch härtbares Epoxidharz,
(b) einen latenten Harnstoff- oder Imidazol-Härter für die Komponente (a), und
(c) einen Eisen-aren-Komplex der Formel (I)

$$[R^1(Fe^{II}R^2)]^{+n}_{n}[X]^{-m}_{m}\ {}_{n} \qquad (I),$$

worin n 1 oder 2 bedeutet, m 1, 2, 3, 4 oder 5 ist, X für ein nicht nukleophiles Anion steht, $R^1$ ein $\pi$-Aren ist und $R^2$ ein Anion eines $\pi$-Arens bedeutet.

**2.** Zusammensetzungen gemäss Anspruch 1, worin die Komponente (b) ein Härter ist, mit welchem die Härtungsreaktion bei einer Temperatur oberhalb 80°C abläuft.

**3.** Zusammensetzungen gemäss Anspruch 1, worin die Komponente (b) Imidazol oder ein Imidazolderivat ist.

**4.** Zusammensetzungen gemäss Anspruch 1, enthaltend 0,1-10 Gew.-%, bezogen auf das Harz (a), der Komponente (b).

**5.** Zusammensetzungen gemäss Anspruch 1, enthaltend als Komponente (c) Komplexe der Formel I, worin X $BF_4^{\ominus}$ , $PF_6^{\ominus}$ , $AsF_6^{\ominus}$ , $SbF_6^{\ominus}$ , $SbF_5OH^{\ominus}$; Sulfonate, wie Methylsulfonat oder p-Toluolsulfonat; Perfluoralkylsulfonate, wie Trifluormethylsulfonat, Nonafluorbutylsulfonat; Acetate, z.B. $CH_3COO^{\ominus}$; ein Perfluoracetat, $F^{\ominus}$, $Cl^{\ominus}$, $Br^{\ominus}$, $I^{\ominus}$; oder ein Pseudohalogenid bedeutet.

**6.** Zusammensetzungen gemäss Anspruch 5, wobei X ein Sulfonat oder ein Perfluoralkylsulfonat ist.

**7.** Zusammensetzungen gemäss Anspruch 1, enthaltend 0,5-20 Gew.-%, bezogen auf das Harz (a), der Komponente (c).

**8.** Zusammensetzung gemäss Anspruch 1, enthaltend zusätzlich einen Sensibilisator für die Komponente (c).

**9.** Zusammensetzung gemäss Anspruch 1, enthaltend ein Bindemittel für eine wässrig-alkalische Entwicklung.

**10.** Zusammensetzung gemäss Anspruch 9, enthaltend als Bindemittel ein Polyphenol oder ein Gemisch von Polyphenolen.

**11.** Verfahren zur Erzeugung positiver Abbildungen umfassend folgende Arbeitsschritte:
- Beschichten eines Substrats mit der positiv arbeitenden Photoresistzusammensetzung gemäss Anspruch 1
- Belichten des beschichteten Substrats mit einem vorbestimmten Muster aktinischer Strahlung
- Härtung des belichteten Substrats bei erhöhter Temperatur, und
- Entwicklung des Substrats.

**Claims**

**1.** A positive-working photoresist composition containing
(a) an epoxide resin which can be hardened by heat,
(b) a latent urea or imidazole hardener for the component (a) and
(c) an iron-arene complex of the formula (I)

$$[R^1(Fe^{II}R^2)_n]_m^{+n}[X]_n^{-m} \qquad (I)$$

in which n is 1 or 2, m is 1, 2, 3, 4 or 5, X is a non-nucleophilic anion, $R^1$ is a $\pi$-arene and $R^2$ is an anion of a $\pi$-arene.

**2.** A composition according to claim 1, wherein the component (b) is a hardener by means of which the hardening reaction takes place at a temperature above 80 ° C.

**3.** A composition according to claim 1, wherein the component (b) is imidazole or an imidazole derivative.

**4.** A composition according to claim 1, containing 0.1-10% by weight, relative to the resin (a), of the component (b).

**5.** A composition according to claim 1, containing, as the component (c), complexes of the formula I in which X is $BF_4^{\ominus}$ , $PF_6^{\ominus}$ , $AsF_6^{\ominus}$ , $SbF_6^{\ominus}$ or $SbF_5OH^{\ominus}$; sulfonates, such as methylsulfonate or p-toluenesulfonate; perfluoroalkylsulfonates, such as trifluoromethylsulfonate or nonafluorobutylsulfonate; acetates, for example $CH_3COO^{\ominus}$; a perfluoroacetate, $F^{\ominus}$, $Cl^{\ominus}$, $Br^{\ominus}$ or $I^{\ominus}$; or a pseudohalide.

**6.** A composition according to claim 5, wherein X is a sulfonate or a perfluoroalkylsulfonate.

**7.** A composition according to claim 1, containing 0.5-20% by weight, relative to the resin (a), of the component (c).

**8.** A composition according to claim 1, containing, in addition, a sensitizer for the component (c).

**9.** A composition according to claim 1, containing a binder for development under aqueous alkaline conditions.

**10.** A composition according to claim 9, containing, as the binder, a polyphenol or a mixture of polyphenols.

**11.** A process for the production of positive images comprising the following working steps:
- coating a substrate with a positive-working photoresist composition according to claim 1,
- exposing the coated substrate to a predetermined pattern of actinic radiation
- hardening the exposed substrate at an elevated temperature and
- developing the substrate.

**Revendications**

**1.** Compositions de photorésist à fonctionnement positif, contenant
(a) une résine époxy thermodurcissable;
(b) un durcisseur latent de type urée ou imidazole pour le constituant (a), et
(c) un complexe arène-fer de formule (I)

$$[R^1(Fe^{II}R^2)_n]_m^{+n}\ [X]_n^{-m} \qquad (I),$$

dans laquelle n signifie 1 ou 2, m est 1, 2, 3, 4 ou 5, X représente un anion non nucléophile, $R^1$ est un arène $\pi$ et $R^2$ représente un anion d'un arène $\pi$.

**2.** Compositions selon la revendication 1, dans lesquelles le constituant (b) est un durcisseur avec lequel la réaction de durcissement se déroule à une température supérieure à 80 °C.

**3.** Compositions selon la revendication 1, dans lesquelles le constituant (b) est l'imidazole ou un dérivé de l'imidazole.

**4.** Compositions selon la revendication 1, contenant 0,1 - 10 % en masse de constituant (b) par rapport à la résine (a).

**5.** Compositions selon la revendication 1, contenant comme constituant (c) des complexes de formule I dans lesquels X représente $BF_4^-$, $PF_6^-$, $AsF_6^-$, $SbF_6^-$, $SbF_5OH^-$; des sulfonates comme le méthylsulfonate ou le p-toluènesulfonate; des perfluoroalkylsulfonates comme le trifluorométhylsulfonate, le nonafluorobutylsulfonate; des acétates, par exemple $CH_3COO^-$; un perfluoroacétate, $F^-$, $Cl^-$, $Br^-$, $I^-$; ou un pseudohalogénure.

**6.** Compositions selon la revendication 5, dans laquelle X est un sulfonate ou un perfluoroalkylsulfonate.

**7.** Compositions selon la revendication 1, contenant 0,5 - 20 % en masse du constituant (c) par rapport à la résine (a).

**8.** Composition selon la revendication 1, contenant en plus un sensibilisateur pour le constituant (c).

**9.** Composition selon la revendication 1, contenant un liant pour un développement en milieu aqueux alcalin.

**10.** Composition selon la revendication 9, contenant comme liant un polyphénol ou un mélange de polyphénols.

**11.** Procédé d'obtention d'images positives comprenant les étapes de travail suivantes:
- le revêtement d'un substrat avec une composition de photorésist à fonctionnement positif selon la revendication 1,
- l'exposition du substrat revêtu avec un dessin prédéterminé à un rayonnement actinique,
- le durcissement du substrat exposé à haute température, et
- le développement du substrat.